Europäisches Patentamt

**European Patent Office**

**Office européen des brevets**

(11) Publication number : **0 494 038 A2**

(12) **EUROPEAN PATENT APPLICATION**

(21) Application number : **91480181.6**

(22) Date of filing : **06.12.91**

(51) Int. Cl.⁵ : **H03M 7/46**

(30) Priority : **31.12.90 US 636783**

(43) Date of publication of application :
**08.07.92 Bulletin 92/28**

(84) Designated Contracting States :
**DE FR GB**

(71) Applicant : **International Business Machines Corporation**
**Old Orchard Road**
**Armonk, N.Y. 10504 (US)**

(72) Inventor : **Nagy, Michael Emmerich**
**8004 Cardinal Drive**
**Tampa, Florida 33617 (US)**

(74) Representative : **Bonneau, Gérard**
**Compagnie IBM France Département de Propriété Intellectuelle**
**F-06610 La Gaude (FR)**

(54) **Run-length encoding in extensible character sets.**

(57) A method of data compression achieved through run-length encoding is disclosed. The method expands a 256 code point eight bit character set to have additional code points. The additional code points provide for the encoding of identical character runs of less then three characters, by assigning numeric weights corresponding to the non-zero digits necessary to express positive integers within a limited range in a specific radix. The presence of the additional echo code points in a data stream are interpreted to mean echo the last normal character the specified number of times. The echo code points are additive in that, the assignment of numeric weights based on non-zero digits in a specific radix, provides an additive sequence to sum to any desired value in the supported range. Also, permitting the highest value code point to be repeated an arbitrary number of times, removes the run length constraints on the upper bounds of identical characters that can be encoded.

Fig. 1

This invention relates to a method of compressing data, and more particularly, to a run length encoder used for pre-compressing input data to a variety of high performance compression algorithms including adaptive algorithms.

Compression is the coding of data to minimize its representation. Compression aids both in increasing the speed of transmitting data and storing it. Various methods of compressing data have been developed over the past few years with particular concentration on the elimination of data redundancy.

There are four basic types of data redundancy. The first type of data redundancy is character distribution where in a typical character string some characters are used more frequently than others. Single character Huffman coding can capably handle this type of data redundancy. The Huffman scheme works by translating fixed size pieces of input data into variable length symbols. In normal use, the size of the input symbol is limited by the size of the translation table needed for compression. A table is needed that list each input symbol and its corresponding code. The disadvantages of the Huffman scheme is its complexity, since the length of each code to be interpreted for decompression purposes is not known until the first few bits are interpreted, as well as an inability to cope with other types of data redundancy. A second type of data redundancy is character repetition wherein a string of repetitions of a single character occurs. In this case, a message can usually be encoded more compactly than by just repeating the character symbol. This type of data redundancy is handled capably using a scheme known as runlength encoding (RLE). Sequences of identical characters are encoded as a count field plus an identifier of the repeated character. While effective for graphical images, this scheme is not effective for text files.

A third type of data redundancy is high usage patterns wherein certain sequences of characters appear with relatively high frequency. The sequences of characters can be represented with relatively fewer bits for a net saving in both time and space. A programmed compression scheme which uses a standard fixed code table will handle this type of redundancy. A disadvantage of this arrangement is that for each type of data file, a code table must be programmed to obtain maximum efficiency.

The fourth type of data redundancy is positional redundancy wherein certain characters appear consistently at predictable place in each block of data. Adaptive compression, which converts variable length strings of input symbols into fixed-length codes, can handle this type of data redundancy. The symbol strings are selected so that all have almost equal probability of occurrence. Adaptive compression a so capably handles the other three types of data redundancy. These various types of data redundancy enable data compression schemes to reduce the size of the data. Recent evidence indicates that a combination of data compression schemes is more effective than a single scheme at handling a variety of the four basic types of data redundancy. Several of these combinations have disclosed the use of runlength encoding (RLE) as a pre-compressor for static Huffman coding as well as adaptive algorithms such as Lempel-Zev.

Run length encoding (RLE), as discussed above, is a data compression scheme where sequences of identical characters or strings of repeating characters are encoded as a count field plus an identifier of the repeated character. The result of the encoding is the production of two characters of overhead (an escape character and a repetition count) to encode runs of identical characters. This limits the usefulness to runs of four or more characters. In addition, prior art RLE schemes suffered from a fixed upper bound on the length of the identical character runs that could be encoded. In addition, data transparency problems arose when binary data was compressed due to the natural presence of all code points (including the escape character) in the data.

Consequently, what is needed is a method of runlength encoding usable either by itself or as a pre-compressor, that is capable of efficiently encoding identical character strings of less then three characters while expanding the upper bound on the length of identical characters. Ideally, the method should eliminate or lessen the data transparency problem caused by the occurrence of all code points plus the escape character in the data.

This invention discloses a method of run-length encoding (RLE) that expands the natural 256 code point eight bit character set to have additional code points. A small set of additional "echo" code points are provided that allows the efficient encoding of identical character runs of less then three characters. The echo code points are assigned numeric weights corresponding to the non-zero digits necessary to express positive integers within a limited range in a specific radix. For example, a radix-3 echo code point would be provided where there was a need for a set of six additional code points to cover the range 1 to 26. The presence of the additional echo code points in a data stream would be interpreted to mean echo the last normal character the specified number of times. The echo code points are additive in that, the assignment of numeric weights based on non-zero digits in a specific radix, provides an additive sequence to sum to any desired value in the supported range. More importantly, allowing the highest value code point to be repeated an arbitrary number of times, removes the run length constraints on the upper bounds.

Figure 1 is a block diagram of the preferred embodiment of the present invention precompression data compression system.

Figure 2 is an example of a radix-3 encoding defining 12 new radix-3 echo code points.

Figure 3 is an example of a data stream encoded using radix-10.

Figure 4 is an example of a data stream encoded using radix-3.

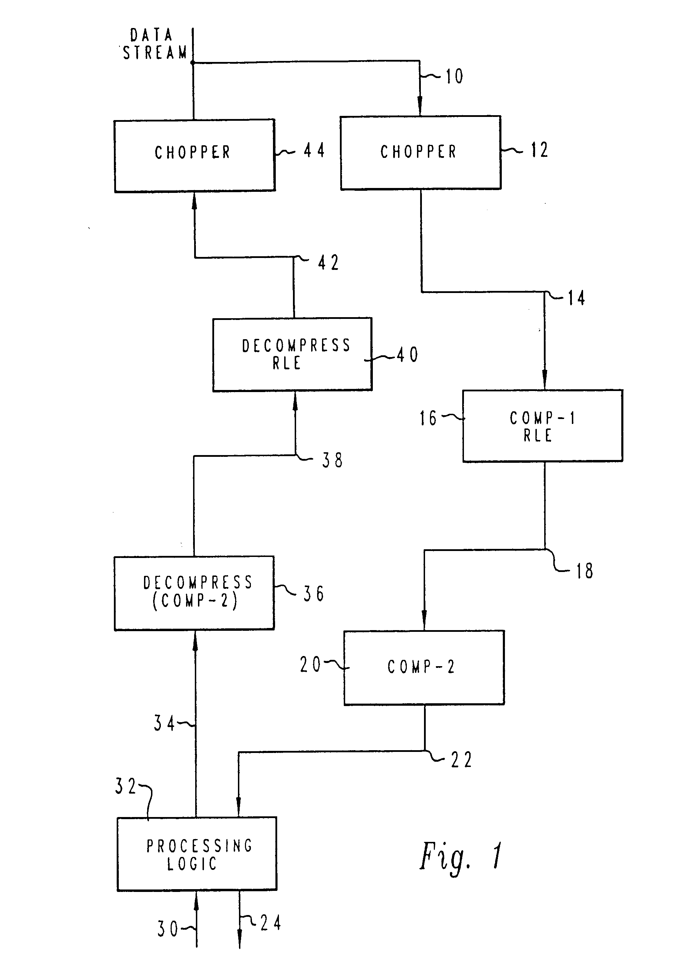

With reference now to the figures, and in particular with reference to Figure 1, there is depicted a block diagram of the preferred embodiment of the present invention precompression data compression system. A bit data stream 10 may be applied to a bit chopper 12 to produce output 14. The bit chopper 12 is used to define the character width of the characters on the bit data stream 10. The output 14 of the chopper 12 is provided as input to the pre-compressor containing the run-length encoder (RLE) 16 as disclosed in this invention. The output 18 of the runlength encoder 16 is then provided to the second stage high performance compression algorithm 20 to produced the doubly compressed output data 22. The high performance compression algorithm 20 may be Huffman or Shannon-Fano as well as more sophisticated adaptive algorithms such as Lempel-Zev. The doubly compressed data stream 22 is then provided as input to processing logic 32 for purposes such as transmission or storage.

It is understood by those skilled in the art that the functions of the run-length encoder 16 are performed on information stored in registers. The run-length encoder 16 may be implemented employing discrete components or performed using a small computer system programmed to carry out the steps of the flow diagram.

Referring again to Figure 1, the decoding portion of the data compression system will be described. A doubly compressed data stream 30 is provided as input to the processing logic 32 which receives the data stream 30 and provides input to the decompression stage-two components 36. The decompression stage-two component 36 would be the complement of the high performance compression algorithm 20. The output 38 of the decompression stage-two component is provided as input to the run-length encoder decompressor 40. The output 42 of the run-length decompressor is provided to a chopper 44 which provides the reconstituted data stream 10 which can be supplied to a host or a channel (not shown).

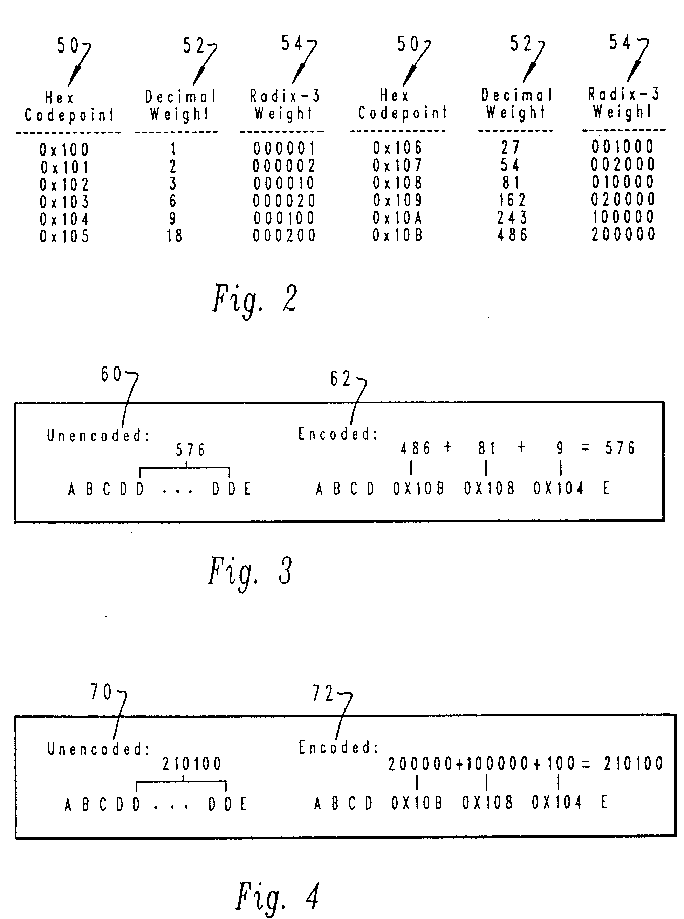

Turning now to Figure 2, there is shown an example of a radix-3 encoding defining 12 new radix-3 echo code points, as would be implemented in the run-length encoder (RLE) 16 of Figure 1. The hexadecimal code point 50 is shown along with the decimal weight 52 and the radix-3 weight 54 for each new code point. Figure 2 illustrates a total of 12 new radix-3 "echo" code points 50 which can be used to encode a run with lengths of up to 728 characters. This encoding is optimally accomplished by representing the repetition count as a radix-3 value, and then encoding the value using the appropriate set of one or more radix-3 echo code points. Runs with lengths longer than 728 may be accommodated either by extending the echo code set to encompass larger radix-3 values, or by simple repetition of the highest weight echo code (0x10B in column 50) until the remaining run length is reduced into the optimal range, and then applying the normal encoding process.

Referring now to Figure 4, an example of a data stream encoded using radix-3 (ternary) will be described. An unencoded data stream 70 is shown which contains a run of "D" characters with a length of 577. The repetition count is 576 which is represented as the radix-3 value 210100. This value has three non-zero radix-3 digits, and may therefore be optimally encoded as indicated using only three radix-3 echo codes 72 (0x10B, 0x108, and 0x104).

Turning now to Figure 3, a data stream encoded using radix-10 (decimal) will be shown. The original unencoded sequence of characters 60, representing 581 bytes, is reduced to a total of eight (8) code points 62. In a prior art run-length encoding scheme, which limits the repetition counts to 32, the same sequence would have required a total of 23 code points to encode. This invention, using radix echo codes, requires fewer code points than the 32 fixed code points shown in prior art run-length encoders. Therefore, this invention -uses less of the communication channel bandwidth for run-length encoding.

This invention is capable of compressing all forms of information that can be represented in digital form whether or not it was derived from printer files, text, data files or graphics data. While the run-length encoder system may be used alone, it is more useful in a universal data compression system having a high performance compression algorithm which further compresses the characters generated at the output of the run length encoder. For example, graphics data in black and white format is predominantly black lines on white background. When such graphics data is raster scanned, and reduced to characters representative of linear portions, there are numerous adjacent redundant characters. The identical characters are compressed or reduced into single characters, then further compressed in the second data compression system.

In summary, this invention discloses a method of run-length encoding that expands a 256 code point eight bit character set to have additional code points. "Echo" code points are provided that allow the encoding of identical character runs of less then three characters. The echo code points are assigned numeric weights corresponding to the non-zero digits necessary to express positive integers within a limited range in a specific radix. The additional echo code points in a data stream are interpreted to mean echo the last normal character the specified number of times. The echo code points are additive in that, the assignment of numeric weights based on non-zero digits in a specific radix, provides an additive sequence to sum to any desired value in the supported range. This implementation allows the highest value code point to be repeated an arbitrary number of times, thus removing the run length constraints on the upper bounds.

further includes the steps of:

decompressing said doubly compressed segment to produce said user data byte and one of said plurality of run length references in radix coding.

**Claims**

1. A method of compressing a user data block into a compressed data block, being characterized in that it comprises the steps of:
   determining whether said received user data byte is identical to the n previous data bytes, the last byte of a string or a single user data byte in one segment of data;
   assigning one of a plurality of run length references to a user data byte using radix notation that is identical to at least the n previous user data bytes, where n is an integer greater than 2.

2. The method of claim 1 characterized int that it further includes the step of:
   providing said compressed data block to a stage two compressor to create a doubly compressed data block.

3. The method of claim 2 characterized in that it includes the steps of:
   decompressing said doubly compressed data block to produce said user compressed data block.

4. A method of compressing a user data block into a compressed data block, being characterized in that it comprises the steps of:
   dividing said user data block into a plurality of equal sized segments of data;
   compressing each of said segments of data in said user data block comprising:
   determining whether said received user data byte in one of said segments of data is identical to the n previous data bytes, the last byte of a string or a single user data byte in one segment of data;
   assigning one of a plurality of run length references to a user data byte using radix coding that is identical to at least the n previous user data bytes, where n is an integer greater than 2.

5. The method of claim 4 characterized in that if further includes the step of:
   providing said compressed segments to a stage two compressor to create a doubly compressed segment.

6. The method of claim 5 characterized in that it

*Fig. 1*

| 50 | 52 | 54 | 50 | 52 | 54 |
|---|---|---|---|---|---|
| Hex Codepoint | Decimal Weight | Radix-3 Weight | Hex Codepoint | Decimal Weight | Radix-3 Weight |
| 0 x 1 0 0 | 1 | 0 0 0 0 0 1 | 0 x 1 0 6 | 2 7 | 0 0 1 0 0 0 |
| 0 x 1 0 1 | 2 | 0 0 0 0 0 2 | 0 x 1 0 7 | 5 4 | 0 0 2 0 0 0 |
| 0 x 1 0 2 | 3 | 0 0 0 0 1 0 | 0 x 1 0 8 | 8 1 | 0 1 0 0 0 0 |
| 0 x 1 0 3 | 6 | 0 0 0 0 2 0 | 0 x 1 0 9 | 1 6 2 | 0 2 0 0 0 0 |
| 0 x 1 0 4 | 9 | 0 0 0 1 0 0 | 0 x 1 0 A | 2 4 3 | 1 0 0 0 0 0 |
| 0 x 1 0 5 | 1 8 | 0 0 0 2 0 0 | 0 x 1 0 B | 4 8 6 | 2 0 0 0 0 0 |

*Fig. 2*

```
60                              62

Unencoded:                      Encoded:      486 +  81  +   9  = 576
              576                              |      |       |
   A B C D D  ...  D D E           A B C D  0X10B  0X108  0X104  E
```

*Fig. 3*

```
70                              72

Unencoded:                      Encoded:  200000+100000+100 = 210100
              210100                          |      |       |
   A B C D D  ...  D D E           A B C D  0X10B  0X108  0X104  E
```

*Fig. 4*